# EUROPÄISCHE PATENTSCHRIFT

(11) **EP 3 849 086 B1**
(45) Veröffentlichungstag und Bekanntmachung des Hinweises auf die Patenterteilung: **24.06.2026**
(21) Anmeldenummer: 21150899.9
(22) Anmeldetag: 11.01.2021
(51) Int. Cl.: H03L 7/095, H03L 7/089

(54) **LOCKDETEKTOR UND PHASEN- ODER VERZÖGERUNGSREGELSCHLEIFE MIT EINEM LOCKDETEKTOR**
LOCK DETECTOR AND PHASE OR DELAY CONTROL LOOP COMPRISING A LOCK DETECTOR
DÉTECTEUR DE BLOCAGE ET BOUCLE DE RÉGULATION DE LA PHASE OU DU RETARD DOTÉ D'UN DÉTECTEUR DE BLOCAGE

(30) Priorität: 13.01.2020 DE 102020200289
(43) Veröffentlichungstag der Anmeldung: 14.07.2021
(73) Patentinhaber: Robert Bosch GmbH, 70442 Stuttgart (DE)
(72) Erfinder: Schubert, Andreas, 01640 Coswig (DE)

(56) Entgegenhaltungen:
- CN-A- 108 183 708
- CN-A- 109 450 441
- CN-B- 101 640 536
- US-A1- 2005 073 343
- US-A1- 2008 191 746

## Beschreibung

Die vorliegende Erfindung betrifft einen Lockdetektor zum Überwachen einer Phasen- oder Verzögerungsregelschleife mit einer von zwei digitalen Steuersignalen gesteuerten Ladungspumpe und eine Phasen- oder Verzögerungsregelschleife mit einem solchen Lockdetektor.

### Stand der Technik

Aus dem Stand der Technik sind Phasenregelschleifen (im Englischen als phaselocked loop (PLL) bezeichnet) und Verzögerungsregelschleifen (im Englischen als delay-locked loop (DLL) bezeichnet) bekannt.

So zeigt das Dokument US 2005/0073343 A1 einen Phasenregelkreis mit einer Verriegelungserkennung. Die Phasenregelkreisschaltung umfasst eine Verriegelungserfassungsschaltung, wobei die Verriegelungserfassungsschaltung einen Generator für ein Verriegelungsdetektions-Startsignal, einen Verriegelungsdetektions-Taktgenerator und einen Verriegelungserfassungssignalgenerator aufweist.

Dokumente CN 109 450 441 A, US 2008/191746 A1, CN 108 183 708 A und CN 101 640 536 B offenbaren ebenfalls Phasenregelkreise mit einer Verriegelungserkennung.

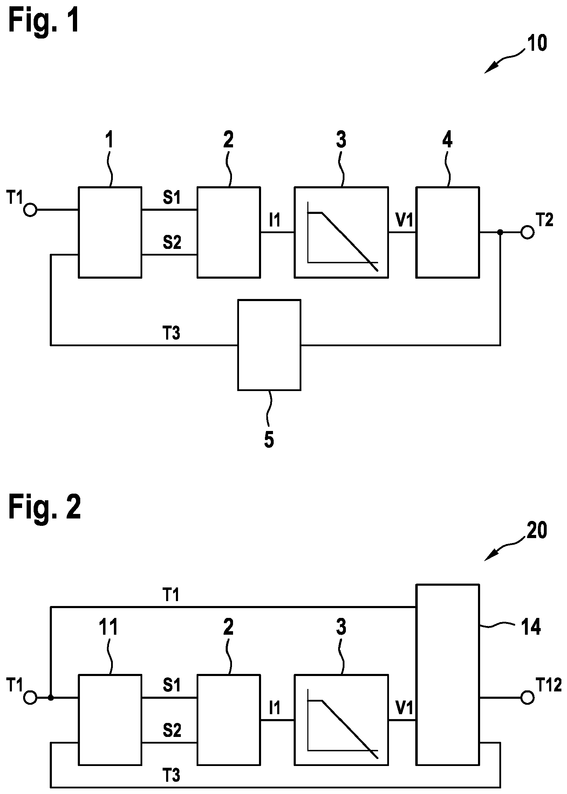

Figur 1 zeigt ein vereinfachtes Blockschaltbild einer Phasenregelschleife 10. Die Phasenregelschleife 10 umfasst einen Phasen- und Frequenz-Detektor 1, eine Ladungspumpe 2, einen Schleifenfilter 3, einen Oszillator 4 und einen Frequenzteiler 5, die in einem Regelkreis angeordnet sind.

Der Phasen- und Frequenz-Detektor 1 ist dazu ausgebildet, ein Referenztaktsignal T1 und ein Rückkoppelungstaktsignal T3 zu empfangen und mittels der empfangenen Signale ein erstes Steuersignal S1 und ein zweites Steuersignal S2 zum Steuern der Ladungspumpe 2 zu erzeugen und auszugeben. Dabei ist das Referenztaktsignal T1 ein Eingangssignal der Phasenregelschleife 10. Ferner ist das Rückkoppelungstaktsignal T3 ein Ausgangssignal des Frequenzteilers 5.

Die Ladungspumpe 2 ist dazu ausgebildet, das erste Steuersignal S1 und das zweite Steuersignal S2 zu empfangen und mittels der empfangenen Signalen einen Strom I1 zu erzeugen und auszugeben.

Der Schleifenfilter 3 ist dazu ausgebildet, den von der Ladungspumpe 2 ausgegebene Strom I1 zu empfangen und mittels des empfangenen Stroms eine Steuerspannung V1 zum Steuern des Oszillators 4 zu erzeugen und auszugeben.

Der Oszillator 4 ist dazu ausgebildet, die Steuerspannung V1 zu empfangen und mittels der empfangenen Steuerspannung ein weiteres Taktsignal T2 zu erzeugen und auszugeben. Das weitere Taktsignal T2 ist ein Ausgangssignal der Phasenregelschleife 10.

Der Frequenzteiler 5 ist dazu ausgebildet, das weitere Taktsignal T2 zu empfangen und mittels des weiteren Taktsignals T2 das Rückkoppelungstaktsignal T3 zu erzeugen und auszugeben.

Figur 2 zeigt ein vereinfachtes Blockschaltbild einer Verzögerungsregelschleife 20.

Die Verzögerungsregelschleife 20 unterscheidet sich von der Phasenregelschleife 10 darin, dass anstelle des Phasen-Frequenzdetektors 1 ein Phasen-Detektor 11 und anstelle des Oszillators 4 eine Verzögerungskette 14 mit einem oder mehreren Verzögerungselementen vorgesehen ist. Die Verzögerungsregelschleife 20 unterscheidet sich ferner von der Phasenregelschleife 10 darin, dass die Verzögerungsregelschleife 20 keinen Frequenzteiler 5 umfasst.

Der Phasen-Detektor 11 ist dazu ausgebildet, das Referenztaktsignal T1 und das Rückkoppelungstaktsignal T3 zu empfangen und mittels der empfangenen Signale das erste Steuersignal S1 und das zweite Steuersignal S2 zum Steuern der Ladungspumpe 2 zu erzeugen und auszugeben. Dabei ist das Referenztaktsignal T1 ein Eingangssignal der Verzögerungsschleife 20. Ferner ist das Rückkoppelungstaktsignal T3 ein Ausgangssignal der Verzögerungskette 14.

Die Verzögerungskette 14 ist dazu ausgebildet, das Referenztaktsignal T1 und die von dem Schleifenfilter 3 ausgegebene Steuerspannung V1 zu empfangen und mittels dieser empfangenen Signale eine zeitverzögerte Variante T12 des Referenztaktsignals T1 und das Rückkoppelungstaktsignal T3 zu erzeugen und auszugeben. Die zeitverzögerte Variante T12 des Referenztaktsignals T1 ist ein Ausgabesignal der Verzögerungsregelschleife 20.

Phasen- und Verzögerungsschleifen können sich in einem eingerasteten Zustand oder in einem nicht eingerasteten Zustand befinden.

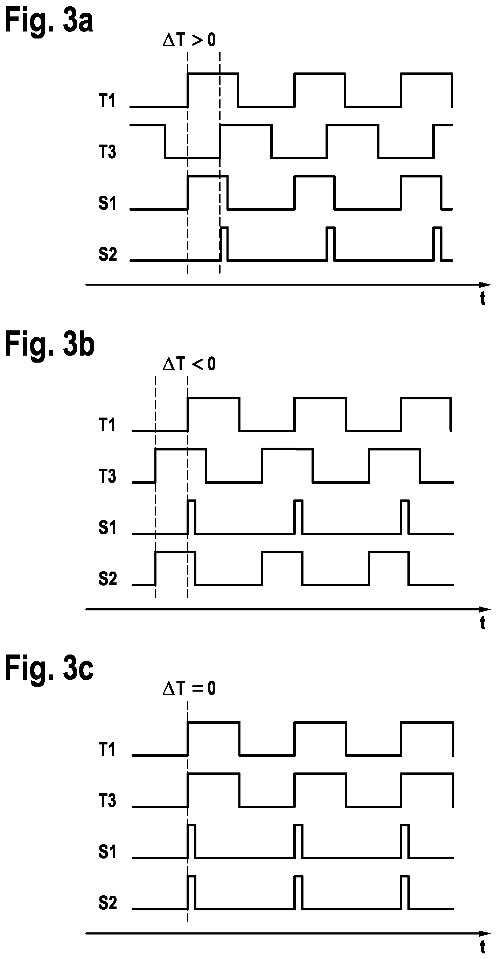

Figur 3a zeigt in Abhängigkeit von der Zeit t dargestellte Verläufe von vier unterschiedlichen Taktsignalen, die während des Betriebs der in der Figur 1 dargestellten Phasenregelschleife 10 oder der in der Figur 2 dargestellten Verzögerungsregelschleife 20 in einem Fall vorkommen, in dem die entsprechende Regelschleife 10, 20 zu langsam und deswegen auch nicht eingerastet ist.

Die vier Taktsignale umfassen das Referenztaktsignal T1 und das Rückkoppelungssignal T3, die von dem Phasen-Frequenz-Detektor 1 der Phasenregelschleife 10 oder dem Phasen-Detektor 11 der Verzögerungsschleife 20 empfangen werden. Die vier Taktsignale umfassen ferner das erste Steuersignal S1 und das zweite Steuersignal S2, die von dem Phasen-Frequenzdetektor 1 der Phasenregelschleife 10 oder dem Phasen-Detektor 11 der Verzögerungsschleife 20 ausgegeben werden.

Die vier Taktsignale sind digitale Taktsignale, die die Werte 0 und 1 annehmen können.

Aus der Figur 3a ist ersichtlich, dass eine zeitliche Differenz ΔT zwischen Zeitpunkten, an denen sich ein Wert des Rückkoppelungstaktsignals T3 von 0 auf 1 ändert, und Zeitpunkten, an denen sich ein Wert des Referenztaktsignals T1 von 0 auf 1 ändert, positiv ist. In anderen Worten ist es aus der Figur 3a ersichtlich, dass eine zeitliche Differenz ΔT zwischen Zeitpunkten, an denen die steigenden Flanken des Rückkoppelungstaktsignals T3 auftreten, und Zeitpunkten, an denen die steigenden Flanken des Referenztaktsignals T1 auftreten, positiv ist. Folglich ist aus der Figur 3a ersichtlich, dass die Phasenregelschleife 10 oder die Verzögerungsregelschleife 20 zu langsam und deswegen auch nicht eingerastet ist.

Figur 3b zeigt in Abhängigkeit von der Zeit t dargestellte Verläufe der vier Taktsignale, die während des Betriebs der Phasenregelschleife 10 oder der Verzögerungsregelschleife 20 in einem Fall vorkommen, in dem die entsprechende Regelschleife 10, 20 zu schnell und deswegen auch nicht eingerastet ist.

Aus der Figur 3b ist ersichtlich, dass die zeitliche Differenz ΔT zwischen den Zeitpunkten, an denen die steigenden Flanken des Rückkoppelungstaktsignals T3 auftreten, und den Zeitpunkten, an denen die steigenden Flanken des Referenztaktsignals T1 auftreten, negativ ist. Folglich ist aus der Figur 3b ersichtlich, dass die Phasenregelschleife 10 oder die Verzögerungsregelschleife 20 zu langsam und deswegen auch nicht eingerastet ist.

Figur 3c zeigt in Abhängigkeit von der Zeit t dargestellte Verläufe der vier Taktsignale, die während des Betriebs der Phasenregelschleife 10 oder der Verzögerungsregelschleife 20 in einem Fall vorkommen, in dem die entsprechende Regelschleife 10, 20 eingerastet ist.

Aus der Figur 3c ist ersichtlich, dass die zeitliche Differenz ΔT zwischen den Zeitpunkten, an denen die steigenden Flanken des Rückkoppelungstaktsignals T3 auftreten, und den Zeitpunkten, an denen die steigenden Flanken des Referenztaktsignals T1 auftreten, gleich 0 ist. Folglich ist aus der Figur 3c ersichtlich, dass die Phasenregelschleife 10 oder die Verzögerungsregelschleife 20 eingerastet ist.

Um einen aktuellen Zustand einer Phasen- oder Verzögerungsregelschleife, die so wie die Phasen- oder Verzögerungsregelschleife 10, 20 aus der Figur 1 oder 2 ausgebildet ist, festzustellen, sind sowohl analoge als auch digitale Ansätze in Gebrauch.

Analoge Ansätze messen in der Regel die Änderung der Steuerspannung V1. Wenn die Änderungsrate hinreichend klein ist, kann die Phasen- oder Verzögerungsregelschleife 10, 20 als eingerastet angesehen werden. Häufig wird dafür ein Spannungsabfall über einen Widerstand im Schleifenfilter 3 gemessen. Da Verzögerungsregelschleifen oft nur mit einem Kondensator kompensiert werden, ist diese Methode nur bei Phasenregelschleifen einfach anwendbar.

Digitale Ansätze werten dagegen einen Phasenfehler zwischen dem Referenztaktsignal T1 und dem Rückkoppelungstaktsignal T3 aus. Die in der Literatur häufig beschriebenen Konzepte vergleichen dazu zwei Zählerstände miteinander. Ein erster Zähler arbeitet mit dem Referenztaktsignal T1 und steuert einen zweiten Zähler, der mit dem Rückkoppelungssignal T3 arbeitet. Wenn beide Zählerstände hinreichen nah beieinander liegen, wird die Phasenregelschleife 10 als eingerastet betrachtet. Für Verzögerungsregelschleifen kann dieses Verfahren nicht angewandt werden, weil sich hier eine Frequenz des Rückkoppelungstaktsignals T3 nicht ändert und die Zählerstände immer gleich wären. Stattdessen werden bei Verzögerungsregelschleifen, die wie die Verzögerungsschleife aus der Figur 2 ausgebildet sind, oft die inneren Zustände der spannungsgesteuerten Verzögerungskette 14 ausgewertet. Die entsprechenden Schaltungen können je nach Anzahl der Verzögerungselemente in der Verzögerungskette 14 sehr groß werden. Andere oft genutzte Ansätze greifen auf Replik-Verzögerungsketten zurück. Auch Konzepte dieser Art vergrößern die entsprechenden Schaltungen erheblich.

### Offenbarung der Erfindung

Es wird ein Lockdetektor zum Überwachen einer Phasen- oder Verzögerungsregelschleife mit einer von zwei digitalen Steuersignalen gesteuerten Ladungspumpe bereitgestellt. Der Lockdetektor umfasst einen ersten Eingang zum Empfangen eines ersten der zwei Steuersignale, einen zweiten Eingang zum Empfangen eines zweiten der zwei Steuersignale und einen Ausgang. Der Lockdetektor umfasst ferner ein UND-Gatter zum Erzeugen einer "UND-Verknüpfungssignal" genannten UND-Verknüpfung der zwei Steuersignale und ein ODER-Gatter zum Erzeugen einer "ODER-Verknüpfungssignal" genannten ODER-Verknüpfung der zwei Steuersignale. Der Lockdetektor umfasst ferner eine Verzögerungseinheit zum Erzeugen einer verzögerten Variante des ODER-Verknüpfungssignals und eine Bearbeitungsschaltung. Die Bearbeitungsschaltung ist dazu ausgebildet, das UND-Verknüpfungssignal und die verzögerte Variante des ODER-Verknüpfungssignals zu empfangen. Die Bearbeitungsschaltung ist ferner dazu ausgebildet, aus den empfangenen Signalen ein erstes Zustandssignal zu erzeugen und über den Ausgang des Lockdetektors auszugeben. Dabei nimmt das Zustandssignal bei Vorliegen eines eingerasteten Zustands der Phasen- oder Verzögerungsregelschleife einen ersten Wert an. Ferner nimmt das Zustandssignal bei Vorliegen eines nicht eingerasteten Zustands der Phasen- oder Verzögerungsregelschleife einen gegenüber dem ersten Wert unterschiedlichen zweiten Wert an.

Vorteilhaft bei dem Lockdetektor ist, dass der erforderliche schaltungstechnische Aufwand sehr gering ist.

Dadurch, dass die Bearbeitungsschaltung aus den zwei Steuersignalen zum Steuern der Ladungspumpe das Zustandssignal erzeugt, wird ermöglicht, dass der Lockdetektor einen aktuellen Zustand der Phasen- oder Verzögerungsregelschleife unabhängig von einem Tastverhältnis eines Referenztaktsignals und eines Rückkoppelungstaktsignals feststellt. Dabei sind das Referenztaktsignal und das Rückkoppelungstaktsignal Eingangssignale eines Phasen-Frequenz-Detektors der Phasenregelschleife oder eines Phasendetektors der Verzögerungsschleife.

Dadurch, dass der Lockdetektor nur eine Verzögerungseinheit und deswegen nur einen Verzögerungspfad umfasst, wird eine verbesserte Reproduzierbarkeit des Verhaltens der Phasen- oder Verzögerungsschleife erreicht, da hier die parametrische Übereinstimmung mehrerer Verzögerungspfade nicht erforderlich ist.

Erfindungsgemäß weist die Bearbeitungsschaltung ein taktflankengesteuertes Flipflop auf. Das Flipflop ist über seinen Datenausgang mit dem Ausgang des Lockdetektors verbunden. Ferner ist das Flipflop dazu ausgebildet, über seinen Dateneingang die verzögerte Variante des ODER-Verknüpfungssignals und über seinen Steuereingang das UND-Verknüpfungssignal als Steuertaktsignal zu empfangen. Weiter umfasst die Bearbeitungsschaltung ein erstes Nicht-Gatter zum Erzeugen einer negierten Variante eines über einen dritten Eingang des Lockdetektors empfangenen Aktivierungssignals. In diesem Fall, ist das Flipflop ferner dazu ausgebildet, über seinen Rücksetzeingang die negierte Variante des Aktivierungssignals zu empfangen.

Durch die Verwendung eines solchen taktflankengesteuerten Flipflops lasst sich die beschriebene Bearbeitungsschaltung aufwandsarm realisieren. Vorzugsweise ist die Verzögerungseinheit ausgebildet, zum Erzeugen der verzögerten Variante des ODER-Verknüpfungssignals das ODER-Verknüpfungssignal um eine Verzögerungszeit zu verzögern, die größer als eine Zeit ist, die einem zulässigen Phasenfehler der Phasen- oder Verzögerungsregelschleife entspricht. In Abhängigkeit von der Länge der Verzögerungszeit kann der Lockdetektor sehr robust gegenüber Störungen ausgestaltet werden.

Erfindungsgemäß umfasst die Bearbeitungsschaltung eine Ausgabeeinheit. Die Ausgabeeinheit ist dazu ausgebildet, bei Vorliegen des eingerasteten Zustands ein an dem Datenausgang des taktgesteuerten Flipflops anliegendes Ausgangssignal zu empfangen und das empfangene Signal zu negieren. Die Ausgabeeinheit ist ferner dazu ausgebildet, das negierte Signal zeitlich um eine oder mehrere Perioden eines Referenztaktsignals zu verzögern und das verzögerte Signal als das den ersten Wert annehmende Zustandssignal über den Ausgang des Lockdetektors auszugeben. Das Referenztaktsignal ist ein von der Phasen- oder Verzögerungsregelschleife empfangenes Eingangssignal. Die Ausgabeeinheit ist ferner dazu ausgebildet, bei Vorliegen des nicht eingerasteten Zustands das an dem Datenausgang des taktgesteuerten Flipflops anliegende Ausgangssignal zu empfangen, das empfangene Signal zu negieren und das negierte Signal sofort als das den zweite Wert annehmende Zustandssignal über den Ausgang des Lockdetektors auszugeben. Die Bearbeitungsschaltung ist als Schieberegister ausgebildet.

Dadurch, dass die Ausgabeeinheit das Zustandssignal, welches auch als LOCK-Signal bezeichnet wird, bei Vorliegen des eingerasteten Zustands zeitlich verzögert ausgibt, wird vermieden, dass ein dynamisches Über- oder Unterschwingen der Phasen- oder Verzögerungsschleife zu einem falschen oder instabilen LOCK-Signal führt.

Dadurch, dass die Ausgabeeinheit das Zustandssignal bei Vorliegen des nicht eingerasteten Zustands sofort ausgibt, wird erreicht, dass der Lockdetektor sofort reagieren kann, wenn die Phasen- oder Verzögerungsschleife ausrastet. Erfindungsgemäß besteht das Schieberegister aus einem weiteren taktflankengesteuerten Flipflop oder aus mehreren weiteren taktflankengesteuerten und in Serie geschalteten Flipflops. Dabei ist ein erstes weiteres Flipflop des Schieberegisters dazu ausgebildet, über seinen Dateneingang das Aktivierungssignal zu empfangen. Ferner ist jedes weitere Flipflop des Schieberegisters dazu ausgebildet, über seinen Rücksetzeingang das an dem Datenausgang des Flipflops anliegende Ausgangssignal und über seinen Steuereingang das Referenztaktsignal als Steuertaktsignal zu empfangen. Weiterhin ist ein zweites weiteres Flipflop des Schieberegisters über seinen Datenausgang mit dem Ausgang des Lockdetektors verbunden. Dabei kann jedes weitere Flipflop des Schieberegisters ein taktflankengesteuertes Flipflop mit asynchronem Rücksetzeingang sein.

Durch die Verwendung eines solchen Schieberegisters lässt sich die Ausgabeeinheit aufwandsarm realisieren.

Bevorzugt ist die Verzögerungseinheit umschaltbar und weist einen ersten und einen zweiten Schaltzustand auf. Dabei ist die in den ersten Schaltzustand geschaltete Verzögerungseinheit ausgebildet, zum Erzeugen der verzögerten Variante des ODER-Verknüpfungssignals das ODER-Verknüpfungssignal um eine erste Verzögerungszeit zu verzögern. Ferner ist die in den zweiten Schaltzustand geschaltete Verzögerungseinheit ausgebildet, zum Erzeugen der verzögerten Variante des ODER-Verknüpfungssignals das ODER-Verknüpfungssignal um eine gegenüber der ersten Verzögerungszeit längere zweite Verzögerungszeit zu verzögern.

Dadurch, dass die Verzögerungseinheit zwei Schaltzustände aufweist, wird erreicht, dass das ODER-Verknüpfungssignal um zwei unterschiedliche Verzögerungszeiten verzögert werden kann, wodurch die Zuverlässigkeit des Lockdetektors erhöht wird.

Vorzugsweise ist die erste Verzögerungszeit größer als eine Zeit, die einem zulässigen Phasenfehler der Phasen- oder Verzögerungsregelschleife entspricht. In Abhängigkeit von der Länge der ersten und der zweiten Verzögerungszeit kann der Lockdetektor sehr robust gegenüber Störungen ausgestaltet werden.

Bevorzugt weist die Bearbeitungsschaltung einen Multiplexer auf, der dazu ausgebildet ist, bei Vorliegen des ersten Wertes des Zustandssignals am Ausgang des Lockdetektors die Verzögerungseinheit in ihren zweiten Schaltzustand zu schalten. Ferner ist der Multiplexer dazu ausgebildet, bei Vorliegen des zweiten Wertes des Zustandssignals am Ausgang des Lockdetektors die Verzögerungseinheit in ihren ersten Schaltzustand zu schalten.

Durch die Verwendung eines solchen Multiplexers wird ermöglicht, eine zuvor beschriebe Verzögerungseinheit in Abhängigkeit von dem Wert des Zustandssignals des Lockdetektors in ihren ersten oder zweiten Schaltzustand zu schalten.

Weiter bevorzugt umfasst die Bearbeitungsschaltung ein zweites Nicht-Gatter zum Erzeugen einer negierten Variante des an dem Datenausgang des taktgesteuerten Flipflops anliegenden Ausgangssignals und zum Ausgeben der negierten Variante als das Zustandssignal über den Ausgang des Lockdetektors. Dadurch, dass das zweites Nicht-Gatter eine negierte Variante des an dem Datenausgang des Flipflops anliegenden Ausgangssignals als das Zustandssignal ausgeben kann, wird erreicht, dass die Bearbeitungsschaltung das Zustandssignal bei Vorliegen des nicht eingerasteten Zustands sofort ausgeben kann. Das bedeutet, dass ein zuvor beschriebener Lockdetektor sofort reagieren kann, wenn die Phasen- oder Verzögerungsschleife ausrastet.

Ferner wird eine Phasen- oder Verzögerungsregelschleife mit einem zuvor beschriebenen Lockdetektor bereitgestellt.

### Kurze Beschreibung der Zeichnungen

Nachfolgend werden Ausführungsbeispiele der Erfindung unter Bezugnahme auf die begleitenden Zeichnungen im Detail beschrieben. Für gleiche Komponenten und Parameter werden jeweils gleiche Bezugszeichen verwendet. Jede Komponente und jeder Parameter werden jeweils einmalig eingeführt und bei Wiederholung jeweils als schon bekannt behandelt, unabhängig davon, auf welche Zeichnung oder auf welches Ausführungsbeispiel sich ein jeweils entsprechender Beschreibungsteil, in dem die entsprechende Komponente oder der entsprechende Parameter wiederholt vorkommt, bezieht. In den Zeichnungen ist:
- Figur 1: eine aus dem Stand der Technik bekannte Phasenregelschleife;
- Figur 2: eine aus dem Stand der Technik bekannte Verzögerungsregelschleife;
- Figur 3a: zeitabhängige Verläufe von vier Taktsignalen, die während des Betriebs der Phasenregelschleife aus Figur 1 oder der Verzögerungsschleife aus der Figur 2 in einem Fall vorkommen, in dem die entsprechende Regelschleife zu langsam und deswegen auch nicht eingerastet ist;
- Figur 3b: zeitabhängige Verläufe der vier Taktsignale, die während des Betriebs der Phasenregelschleife aus Figur 1 oder der Verzögerungsschleife aus der Figur 2 in einem Fall vorkommen, in dem die entsprechende Regelschleife zu schnell und deswegen auch nicht eingerastet ist;
- Figur 3c: zeitabhängige Verläufe der vier Taktsignale, die während des Betriebs der Phasenregelschleife aus der Figur 1 oder der Verzögerungsschleife aus der Figur 2 in einem Fall vorkommen, in dem die entsprechende Regelschleife eingerastet ist;
- Figur 4: ein erster Lockdetektor gemäß einer ersten Ausführungsform der Erfindung;
- Figur 5: ein zweiter Lockdetektor gemäß einer zweiten Ausführungsform der Erfindung; und
- Figur 6: zeitabhängige Verläufe aller wichtigen Taktsignale und Größen, die während des Betriebs der mittels des ersten oder des zweiten Lockdetektors überwachten Phasenregelschleife aus der Figur 1 oder der mittels des ersten oder des zweiten Lockdetektors überwachten Verzögerungsschleife aus der Figur 2 vorkommen.

### Ausführungsformen der Erfindung

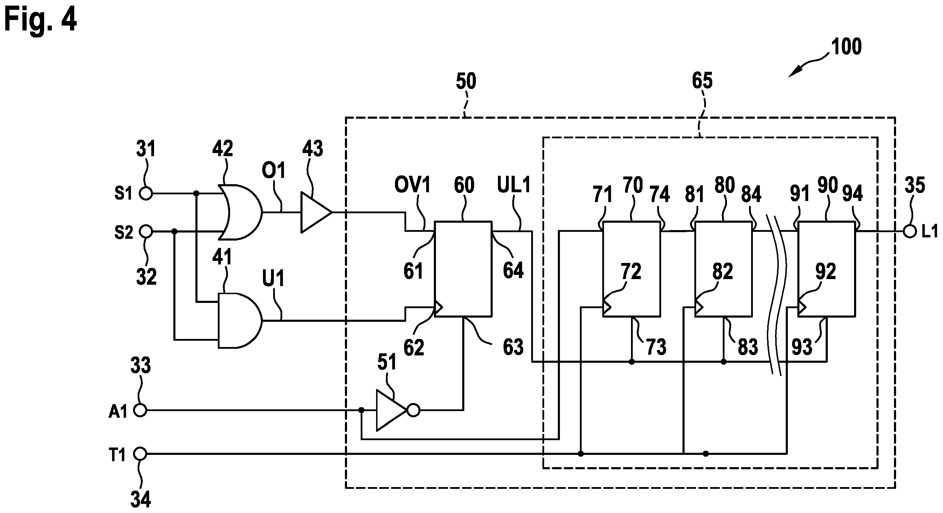

Figur 4 zeigt einen ersten Lockdetektor 100 gemäß einer ersten Ausführungsform der Erfindung.

Der erste Lockdetektor 100 ist zum Überwachen einer Phasen- oder Verzögerungsregelschleife, die wie die Phasen- oder Verzögerungsregelschleife 10, 20 aus der Figur 1 oder 2 ausgebildet ist und die von dem ersten digitalen Steuersignal S1 und von dem zweiten digitalen Steuersignal S2 gesteuerte Ladungspumpe 2 aufweist.

Der erste Lockdetektor 100 umfasst einen ersten Eingang 31 zum Empfangen des ersten Steuersignals S1 zum Steuern der Ladungspumpe 2 und einen zweiten Eingang 32 zum Empfangen des zweiten Steuersignals S2 zum Steuern der Ladungspumpe 2. Der erste Lockdetektor 100 umfasst ferner einen dritten Eingang 33 zum Empfangen eines Aktivierungssignal A1 und einen vierten Eingang 34 zum Empfangen des von der Phasen- oder Verzögerungsschleife 10, 20 als Eingangssignal empfangenen Referenztaktsignals T1. Der erste Lockdetektor 100 umfasst ferner einen Ausgang 35.

Der erste Lockdetektor 100 umfasst ferner ein UND-Gatter 41 zum Erzeugen einer "UND-Verknüpfungssignal" U1 genannten UND-Verknüpfung der zwei Steuersignale S1, S2.

Der erste Lockdetektor 100 umfasst ferner ein ODER-Gatter 42 zum Erzeugen einer "ODER-Verknüpfungssignal" O1 genannten ODER-Verknüpfung der zwei Steuersignale S1, S2.

Der erste Lockdetektor 100 umfasst ferner eine Verzögerungseinheit 43 zum Erzeugen einer um eine Verzögerungszeit τ verzögerten Variante OV1 des ODER-Verknüpfungssignals O1.

Die Verzögerungszeit τ ist größer als eine Zeit, die einem zulässigen Phasenfehler der Phasen- oder Verzögerungsregelschleife 10, 20 entspricht. In anderen Worten wird die Verzögerungszeit τ so groß ausgewählt, dass alle Toleranzen abgedeckt sind, die sich in einem Zeitoffset ΔT_{OFFSET} manifestieren, der einem zulässigen Phasenoffset entspricht. Dabei wird die Phasen- oder Verzögerungsregelschleife 10, 20 als eingerastet eingesehen, wenn der Betrag der zeitlichen Differenz ΔT kleiner als die Verzögerungszeit τ ist, d.h. wenn die Ungleichung |ΔT| < τ gültig ist. Ferner wird die Phasen- oder Verzögerungsregelschleife 10, 20 als nicht eingerastet eingesehen, wenn die Ungleichung |ΔT| > τ gültig ist. Die zeitliche Differenz ΔT ist der zeitliche Abstand zwischen den Zeitpunkten, an denen die steigenden Flanken des Rückkoppelungstaktsignals T3 auftreten, und den Zeitpunkten, an denen die steigenden Flanken des Referenztaktsignals T1 auftreten.

Der erste Lockdetektor 100 umfasst ferner eine Bearbeitungsschaltung 50, die dazu ausgebildet das UND-Verknüpfungssignal U1 und die verzögerte Variante des ODER-Verknüpfungssignals OV1 zu empfangen. Die Bearbeitungsschaltung 50 ist ferner dazu ausgebildet, aus diesen empfangenen Signalen ein digitales Zustandssignal L1 zu erzeugen und über den Ausgang 35 des ersten Lockdetektors 100 auszugeben. Dabei nimmt das digitale Zustandssignal L1 bei Vorliegen eines eingerasteten Zustands der Phasen- oder Verzögerungsregelschleife 10, 20 einen ersten Wert an, der gleich 1 ist. Ferner nimmt das digitale Zustandssignal L1 bei Vorliegen eines nicht eingerasteten Zustands der Phasen- oder Verzögerungsregelschleife 10, 20 einen zweiten Wert an, der gleich 0 ist.

Das digitale Zustandssignal L1 wird auch als LOCK-Signal bezeichnet.

Die Bearbeitungsschaltung 50 weist ein erstes Nicht-Gatter 51 zum Erzeugen einer negierten Variante des Aktivierungssignals A1.

Die Bearbeitungsschaltung 50 weist ein taktflankengesteuertes Flipflop 60 auf, das dazu ausgebildet ist, über seinen Dateneingang 61 die verzögerte Variante OV1 des ODER-Verknüpfungssignals O1 und über seinen Steuereingang 62 das UND-Verknüpfungssignal U1 zu empfangen. Das Flipflop 60 ist ferner dazu ausgebildet, über seinen Rücksetzeingang 63 die negierte Variante des Aktivierungssignals A1 zu empfangen. Das bedeutet, dass das UND-Verknüpfungssignal U1 ein Steuertaktsignal erzeugt, mit dem das Flipflop 60 einen Wert an seinem Dateneingang 61 als Wert an seinem Datenausgang 64 übernimmt, wobei der Wert an seinem Dateneingang 61 der Wert der verzögerten Variante OV1 des ODER-Verknüpfungssignals O1 ist.

Ferner kann das Flipflop 60 über seinen Datenausgang 64 direkt oder indirekt, über Rücksetzeingänge 73, 83, 93 mehrerer weiterer taktflankengesteuerter Flipflops 70, 80, 90 einer im Folgenden näher beschriebenen Ausgabeeinheit 65, mit dem Ausgang 35 des ersten Lockdetektors 100 verbunden sein. Bevorzugt ist das Flipflop 60 ein taktflankengesteuertes Flipflop mit asynchronem Rücksetzeingang.

Es ist hier zu berücksichtigen, dass ein taktflankengesteuertes Flipflop bei Vorliegen jeder steigenden Flanke eines Steuertaktsignals an seinem Steuereingang einen Wert an seinem Dateneingang als Wert an seinem Datenausgang übernimmt. Der Wert an dem Datenausgang eines solchen Flipflops bleibt danach konstant, egal wie sich ein Signal an dem Dateneingang desselben Flipflops zwischenzeitlich verhält, und ändert sich erst mit der nächsten steigenden Flanke des Steuertaktsignals an seinem Steuereingang.

Wird ein taktflankengesteuertes Flipflop mit asynchronem Rücksetzeingang mit einer logischen Eins an seinem Rücksetzeingang zurückgesetzt, so wird sich an seinem Datenausgang eine logische Null unverzüglich und für die Dauer der logischen Eins an seinem Rücksetzeingang einstellen. Der Wert an dem Datenausgang eines solchen Flipflops ist während dieser Dauer unabhängig sowohl von dem Signal an seinem Dateneingang als auch von dem Steuertaktsignal an seinem Steuereingang. Im Gegensatz dazu wird der Wert an dem Rücksetzeingang eines taktflankengesteuerten Flipflops mit synchronem Rücksetzeingang erst mit der folgenden steigenden Flanke des Steuertaktsignals an seinem Steuereingang wirksam.

Die Bearbeitungsschaltung 50 umfasst ferner die Ausgabeeinheit 65. Die Ausgabeeinheit 65 ist dazu ausgebildet, bei Vorliegen des eingerasteten Zustands ein an dem Datenausgang 63 des taktgesteuerten Flipflops 60 anliegendes Ausgangssignal UL1 zu empfangen und das empfangene Signal zu negieren. Die Ausgabeeinheit 65 ist ferner dazu ausgebildet, das negierte Signal um eine oder mehrere Perioden des Referenztaktsignals T1 zu verzögern und das verzögerte Signal als das den ersten Wert annehmende Zustandssignal L1 über den Ausgang 35 des ersten Lockdetektors 100 auszugeben. Die Ausgabeeinheit 65 ist ferner dazu ausgebildet, bei Vorliegen des nicht eingerasteten Zustands das an dem Datenausgang 63 des taktgesteuerten Flipflops 60 anliegende Ausgangssignal UL1 zu empfangen, das empfangene Signal zu negieren und das negierte Signal sofort als das den zweiten Wert annehmende Zustandssignal L1 über den Ausgang 35 des ersten Lockdetektors 100 auszugeben.

Die Ausgabeeinheit 65 ist als Schieberegister ausgebildet. Das Schieberegister besteht aus den mehreren weiteren taktflankengesteuerten und in Serie geschalteten Flipflops 70, 80, 90. Jedes weitere Flipflop 70, 80, 90 des Schieberegisters ist ein taktflankengesteuertes Flipflop mit asynchronem Rücksetzeingang und umfasst einen Dateneingang 71, 81, 91, einen Steuereingang 72, 82, 92, einen Rücksetzeingang 73, 83, 93 und einen Datenausgang 74, 84, 94.

Ferner ist ein erstes weiteres Flipflop 70 des Schieberegisters dazu ausgebildet, über seinen Dateneingang 71 das Aktivierungssignal A1 zu empfangen. Auch ist jedes weitere taktgesteuerte Flipflop 70, 80, 90 des Schieberegisters dazu ausgebildet, über seinen Steuereingang 72, 73, 74 das Referenztaktsignal T1 als Steuertaktsignal und über seinen Rücksetzeingang 73, 83, 93 das an dem Datenausgang 64 des taktgesteuerten Flipflops 60 anliegende Ausgangssignal UL1 zu empfangen. Weiterhin ist ein zweites weiteres Flipflop 90 des Schieberegisters über seinen Datenausgang 94 mit dem Ausgang 35 des ersten Lockdetektors 100 verbunden.

Das Schieberegister kann auch aus einem einzelnen weiteren taktflanken gesteuerten Flipflop bestehen. In diesem Fall stellt dieses einzelne Flipflop das erste weitere taktgesteuerte Flipflop des Schieberegisters, das zweite weitere taktgesteuerte Flipflop des Schieberegisters und jedes weitere taktgesteuerte Flipflop des Schieberegisters dar.

Mittels des Schieberegisters wird folglich erreicht, dass der erste Lockdetektor 100 seine Ausgabe, dass die Phasen- oder Verzögerungsschleife 10, 20 eingerastet ist, um eine oder mehrere Perioden des Referenztaktsignals T1 verzögert. Falls jedoch die Phasen- oder Verzögerungsschleife 10, 20 nicht eingerastet ist, erfolgt die Ausgabe der entsprechenden Zustandsänderung sofort. Damit ist bei hinreichender Registerlänge sichergestellt, dass ein dynamisches Über- oder Unterschwingen der die Phasen- oder Verzögerungsschleife 10, 20 nicht zu einem falschen oder instabilen Zustandssignal L1 führt.

Gemäß einer ersten Variante der ersten Ausführungsform, ist die Ausgabeeinheit 65 als ein in geeigneter Weise konstruierter Zähler ausgebildet.

Bei der ersten Ausführungsform der Erfindung wurden die Laufzeiten der verwendeten Gatter vernachlässigt.

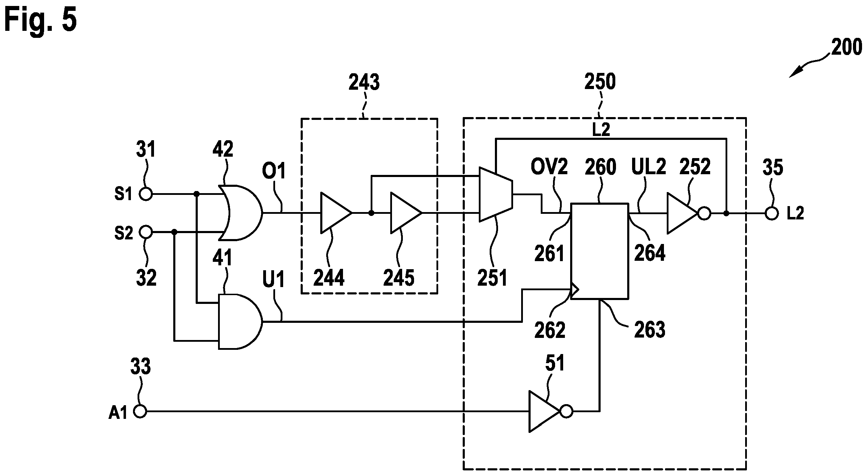

Figur 5 zeigt ein zweiter Lockdetektor 200 gemäß einer zweiten Ausführungsform der Erfindung. Der zweite Lockdetektor 200 unterscheidet sich von dem ersten Lockdetektor 100 darin, dass anstelle der Verzögerungseinheit 43 eine weitere Verzögerungseinheit 243 vorgesehen ist und anstelle der Bearbeitungsschaltung 50 eine weitere Bearbeitungsschaltung 250 vorgesehen ist. Der zweite Lockdetektor 200 unterscheidet sich von dem ersten Lockdetektor 100 ferner darin, dass der zweite Lockdetektor 200 keinen vierten Eingang 34 und auch keine Ausgabeeinheit 65 aufweist.

Die weitere Verzögerungseinheit 243 ist umschaltbar und weist einen ersten und einen zweiten Schaltzustand auf. Die in den ersten Schaltzustand geschaltete weitere Verzögerungseinheit 243 ist ausgebildet, zum Erzeugen einer weiteren verzögerten Variante OV2 des ODER-Verknüpfungssignals O1 das ODER-Verknüpfungssignal O1 mittels eines ersten Verzögerungselements 244 um eine erste Verzögerungszeit τ1 zu verzögern. Die in den zweiten Schaltzustand geschaltete weitere Verzögerungseinheit 243 ist ausgebildet, zum Erzeugen der weiteren verzögerten Variante OV2 des ODER-Verknüpfungssignals O1 das ODER-Verknüpfungssignal O1 mittels des ersten Verzögerungselement 244 und eines zweiten Verzögerungselements 245 um eine gegenüber der ersten Verzögerungszeit τ1 längere zweite Verzögerungszeit τ1' zu verzögern. Dabei gilt die Gleichung τ1' = τ1+τ, wobei τ2 eine mittels des zweiten Verzögerungselements 245 bewirkte Verzögerungszeit ist.

Die erste Verzögerungszeit τ1 ist größer als eine Zeit, die einem zulässigen Phasenfehler der Phasen- oder Verzögerungsregelschleife 10, 20 entspricht. In anderen Worten wird die erste Verzögerungszeit τ1 so groß ausgewählt, dass alle Toleranzen abgedeckt sind, die sich in einem Zeitoffset ΔT_{OFFSET} manifestieren, der einem zulässigen Phasenoffset entspricht. So wird eine zuverlässige Bewertung eines aktuellen Zustands der Phasen- oder Verzögerungsregelschleife 10, 20 erreicht. Dabei wird die Phasen- oder Verzögerungsregelschleife 10, 20 als eingerastet eingesehen, wenn der Betrag der zeitlichen Differenz ΔT kleiner als die erste Verzögerungszeit τ1 ist, d.h. wenn die Ungleichung |ΔT| < τ1 gültig ist. Ferner wird die Phasen- oder Verzögerungsregelschleife 10, 20 als nicht eingerastet eingesehen, wenn die Ungleichung |ΔT| > τ1+τ2 gültig ist. Die zeitliche Differenz ΔT ist der zeitliche Abstand zwischen den Zeitpunkten, an denen die steigenden Flanken des Rückkoppelungstaktsignals T3 auftreten, und den Zeitpunkten, an denen die steigenden Flanken des Referenztaktsignals T1 auftreten.

Folglich liegt zwischen dem eingerasteten und dem nicht eingerasteten Zustand der Phasen- oder Verzögerungsregelschleife 10, 20 eine zeitliche Hysterese von τ2.

Die weitere Bearbeitungsschaltung 250 ist dazu ausgebildet das UND-Verknüpfungssignal U1 und die weitere verzögerte Variante des ODER-Verknüpfungssignals OV2 zu empfangen. Die weitere Bearbeitungsschaltung 250 ist ferner dazu ausgebildet, aus diesen empfangenen Signalen ein weiteres digitales Zustandssignal L2 zu erzeugen und über den Ausgang 35 des zweiten Lockdetektors 100 auszugeben. Dabei nimmt das weitere digitale Zustandssignal L2 bei Vorliegen eines eingerasteten Zustands der Phasen- oder Verzögerungsregelschleife 10, 20 einen ersten Wert an, der gleich 1 ist. Ferner nimmt das digitale Zustandssignal L1 bei Vorliegen eines nicht eingerasteten Zustands der Phasen- oder Verzögerungsregelschleife 10, 20 einen zweiten Wert an, der gleich 0 ist.

Das weitere digitale Zustandssignal L2 wird auch als weiteres LOCK-Signal bezeichnet.

Die weitere Bearbeitungsschaltung 250 weist das erste Nicht-Gatter 51 zum Erzeugen der negierten Variante des Aktivierungssignals A1.

Die weitere Bearbeitungsschaltung 250 weist ein taktflankengesteuertes Flipflop 260 auf. Dieses Flipflop 260 ist dazu ausgebildet, über seinen Dateneingang 61 die weitere verzögerte Variante OV2 des ODER-Verknüpfungssignals O1, über seinen Steuereingang 262 das UND-Verknüpfungssignal U1 zu empfangen und über seinen Rücksetzeingang 263 die negierte Variante des Aktivierungssignals A1 zu empfangen.

Ferner ist das Flipflop 260 der weiteren Bearbeitungsschaltung 250 über seinen Datenausgang 264 mit dem Ausgang 35 des zweiten Lockdetektors 200 verbunden. Bevorzugt ist dieses Flipflop 260 ein taktflankengesteuertes Flipflop mit asynchronem Rücksetzeingang.

Die weitere Bearbeitungsschaltung 250 weist ferner einen Multiplexer 251 auf. Der Multiplexer 251 ist dazu ausgebildet, bei Vorliegen des ersten Wertes des weiteren Zustandssignals L2 am Ausgang 35 des zweiten Lockdetektors 200 die weitere Verzögerungseinheit 243 in ihren zweiten Schaltzustand zu schalten. Der Multiplexer 251 ist ferner dazu ausgebildet, bei Vorliegen des zweiten Wertes des weiteren Zustandssignals L2 am Ausgang 35 des zweitem Lockdetektors 200 die weitere Verzögerungseinheit 243 in ihren ersten Schaltzustand zu schalten.

Die weitere Bearbeitungsschaltung 250 umfasst ferner ein zweites Nicht-Gatter 252 zum Erzeugen einer negierten Variante des an dem Datenausgang 264 des Flipflops 260 der weiteren Bearbeitungsschaltung 250 anliegenden Ausgangssignals UL2 und zum Ausgeben der negierten Variante als das weitere Zustandssignal L2 über den Ausgang 35 des zweiten Lockdetektors 200.

Bei der zweiten Ausführungsform der Erfindung wurden die Laufzeiten der verwendeten Gatter vernachlässigt.

Je nach Anwendungsfall kann sich auch eine Kombination der ersten und der zweiten Ausführungsform der Erfindung als nützlich erweisen.

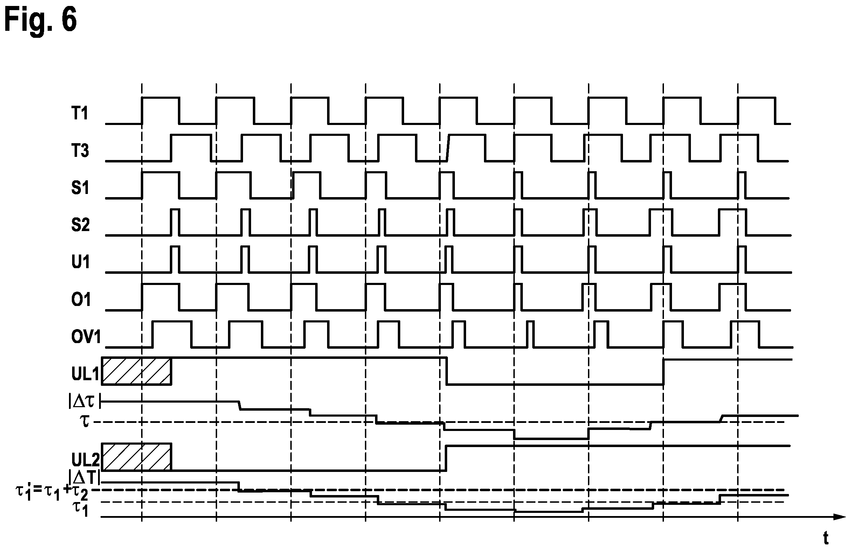

Figur 6 zeigt in Abhängigkeit von der Zeit t dargestellte Verläufe aller wichtigen Taktsignale und Größen, die während des Betriebs einer mittels des ersten oder des zweiten Lockdetektors 100, 200 überwachten Phasen- oder Verzögerungsregelschleife vorkommen, die wie die Phasen- oder Verzögerungsregelschleife 10, 20 aus der Figur 1 oder 2 ausgebildet ist. Im Folgenden werden diese Taktsignale und Größen in der Reihenfolge beschrieben, wie sie in der Figur 6 von oben nach unten erscheinen.

In der Figur 6 ist in durchgezogener Linie ein zeitabhängiger Verlauf des Referenztaktsignals T1 aus den Figuren 1 und 2 als erster Verlauf eingezeichnet.

Unmittelbar unter dem Referenztaktsignal T1 ist in der Figur 6 in durchgezogener Linie ein zeitabhängiger Verlauf des Rückkoppelungstaktsignals T3 aus den Figuren 1 und 2 eingezeichnet.

Unmittelbar unter dem Rückkoppelungstaktsignal T3 ist in der Figur 6 in durchgezogener Linie ein zeitabhängiger Verlauf des ersten Steuersignals S1 aus den Figuren 1 und 2 eingezeichnet.

Unmittelbar unter dem ersten Steuersignal S1 ist in der Figur 6 in durchgezogener Linie ein zeitabhängiger Verlauf des zweiten Steuersignals S2 aus den Figuren 1 und 2 eingezeichnet.

Unmittelbar unter dem zweiten Steuersignal S2 ist in der Figur 6 in durchgezogener Linie ein zeitabhängiger Verlauf des UND-Verknüpfungssignals U1 aus den Figuren 4 und 5 eingezeichnet.

Unmittelbar unter dem UND-Verknüpfungssignal U1 ist in der Figur 6 in durchgezogener Linie ein zeitabhängiger Verlauf des ODER-Verknüpfungssignals O1 aus den Figuren 4 und 5 eingezeichnet.

Unmittelbar unter dem ODER-Verknüpfungssignal O1 ist in der Figur 6 in durchgezogener Linie ein zeitabhängiger Verlauf der verzögerten Variante OV1 des ODER-Verknüpfungssignals O1 aus der Figur 4 eingezeichnet.

Unmittelbar unter der verzögerte Variante OV1 des ODER-Verknüpfungssignals O1 aus der Figur 4 ist in der Figur 6 in durchgezogener Linie ein zeitabhängiger Verlauf eines Ausgangssignal UL1 der Bearbeitungsschaltung 50 aus der Figur 4 eingezeichnet. Dieses Ausgangssignal UL1 ist das an dem Datenausgang 64 des Flipflops 60 der Bearbeitungsschaltung 50 aus der Figur 4 anliegende Ausgangssignal UL1. Die Schraffur am Anfang des zeitabhängigen Verlaufs dieses Ausgangssignals UL1 zeigt an, dass hier der Zustand der Phasen- oder Verzögerungsschleife 10, 20 unbekannt ist.

Unmittelbar unter dem Ausgangssignals UL1 der Bearbeitungsschaltung 50 aus der Figur 4 ist in der Figur 6 in durchgezogener Linie ein zeitabhängiger Verlauf des Betrages der zeitlichen Differenz |ΔT| eingezeichnet. Diese zeitliche Differenz ΔT ist der zeitliche Abstand zwischen den Zeitpunkten, an denen die steigenden Flanken des Rückkoppelungstaktsignals T3 auftreten, und den Zeitpunkten, an denen die steigenden Flanken des Referenztaktsignals T1 auftreten.

Unmittelbar unter dem Betrag der zeitlichen Differenz |ΔT| ist in der Figur 6 in unterbrochener Linie ein zeitabhängiger Verlauf der Verzögerungszeit τ eingezeichnet, mit der das ODER-Verknüpfungssignal O1 mittels der Verzögerungseinheit 43 aus der Figur 4 verzögert wird.

Unmittelbar unter der Verzögerungszeit c ist in der Figur 6 in durchgezogener Linie ein zeitabhängiger Verlauf eines Ausgangssignals L2 der weiteren Bearbeitungsschaltung 250 aus der Figur 5 eingezeichnet. Dieses Ausgangssignal L2 ist das an dem Ausgang 35 des zweiten Lockdetektors 200 aus der Figur 5 anliegende weitere Zustandssignal L2. Die Schraffur am Anfang des zeitabhängigen Verlaufs dieses Ausgangssignals L2 bedeutet, dass hier der Zustand der Phasen- oder Verzögerungsschleife 10, 20 unbekannt ist.

Unmittelbar unter dem Ausgangssignals L2 der weiteren Bearbeitungsschaltung 250 aus der Figur 5 ist in der Figur 6 in durchgezogener Linie der zeitabhängige Verlauf des Betrages der zeitlichen Differenz |ΔT| erneut eingezeichnet.

Unmittelbar unter dem Betrag der erneut eingezeichneten zeitlichen Differenz |ΔT| ist in der Figur 6 in unterbrochener Linie ein zeitabhängiger Verlauf der zweiten Verzögerungszeit τ1' = τ1+τ2 eingezeichnet, mit der das ODER-Verknüpfungssignal O1 mittels der in dem zweiten Schaltzustand geschalteten weiteren Verzögerungseinheit 243 aus der Figur 5 verzögert wird.

Unmittelbar unter der zweiten Verzögerungszeit τ1' ist in der Figur 6 in unterbrochener Linie ein zeitabhängiger Verlauf der ersten Verzögerungszeit τ1 eingezeichnet, mit der das ODER-Verknüpfungssignal O1 mittels der in dem ersten Schaltzustand geschalteten weiteren Verzögerungseinheit 243 aus der Figur 5 verzögert wird.

Aus den zeitabhängigen Verläufen des Rückkoppelungstaktsignals T3 und des Referenztaktsignals T1 ist ersichtlich, dass zu Beginn einer Betriebsperiode der Phasen- oder Verzögerungsregelschleife 10, 20 die steigenden Flanken des Rückkoppelungstaktsignals T3 nach den steigenden Flanken des Referenztaktsignals T1 erscheinen, so dass die Ungleichung ΔT > 0 erfüllt ist. Mit steigender Zeit t wird die zeitliche Differenz ΔT immer kleiner bis am Ender der Darstellung aus der Figur 6 die Ungleichung ΔT < 0 erfüllt ist. Wenn nun der Fall eintritt, in dem die Ungleichung ΔT < 0 erfüllt ist, wird die verzögerte Variante OV1 des ODER-Verknüpfungssignals O1 aus der Figur 4, der das Signal am Dateneingang 61 des Flipflops 60 der Bearbeitungsschaltung 50 aus der Figur 4 ist, einen Wert von 1 erst nach dem Erscheinen der steigenden Flanke am Steuereingang 62 desselben Flipflops 60 annehmen. Damit wechselt der Wert des an dem Datenausgang 63 des Flipflops 60 der Bearbeitungsschaltung 50 anliegenden Ausgangssignals UL1 von 1 auf 0. Die Phasen- oder Verzögerungsschleife 10, 20 wird als eingerastet angesehen. Der zeitliche Verlauf des ODER-Verknüpfungssignals O1 bewirkt hier die zeitliche Betragsbildung.

In der Figur 5 ist der zweite Lockdetektor 200, der ein Lockdetektor mit Hysterese ist, dargestellt. Dessen Verhalten ist vor allem in den unteren vier zeitabhängigen Verläufen der Figur 6 dargestellt. Aus diesen Verläufen ist ersichtlich, dass, sobald die Ungleichung |ΔT| < τ1 erfüllt ist, der Wert des Ausgangssignals L2 des zweiten Lockdetektors 200 von 0 auf 1 wechselt und der Multiplexer 251 umgeschaltet wird. Nun wird das ODER-Verknüpfungssignal O1 um den Betrag τ' = τ1+ τ2 verzögert. Damit der Wert des Ausgangssignals L2 des zweiten Lockdetektors 200 von 1 auf 0 wechseln kann, muss die Ungleichung |ΔT| > τ1+ τ2 erfüllt sein. Damit hat die Phasen- oder Verzögerungsregelschleife eine zeitliche Hysterese von τ2.

## Patentansprüche

1. Lockdetektor (100; 200) zum Überwachen einer Phasen- oder Verzögerungsregelschleife (10, 20) mit einer von zwei digitalen Steuersignalen (S1, S2) gesteuerten Ladungspumpe (2) umfassend:
einen ersten Eingang (31) zum Empfangen eines ersten (S1) der zwei Steuersignale (S1, S2);
einen zweiten Eingang (32) zum Empfangen eines zweiten (S2) der zwei Steuersignale (S1, S2);
einen Ausgang (35);
ein UND-Gatter (41) zum Erzeugen einer "UND-Verknüpfungssignal" (U1) genannten UND-Verknüpfung der zwei Steuersignale (S1, S2);
ein ODER-Gatter (42) zum Erzeugen einer "ODER-Verknüpfungssignal" (O1) genannten ODER-Verknüpfung der zwei Steuersignale (S1, S2);
eine Verzögerungseinheit (43; 243) zum Erzeugen einer verzögerten Variante (OV1; OV2) des ODER-Verknüpfungssignals (O1); und
eine Bearbeitungsschaltung (50; 250), die dazu ausgebildet das UND-Verknüpfungssignal (U1) und die verzögerte Variante (OV1; OV2) des ODER-Verknüpfungssignals (O1) zu empfangen und aus den empfangenen Signalen ein digitales Zustandssignal (L1; L2), das bei Vorliegen eines eingerasteten Zustands der Phasen- oder Verzögerungsregelschleife (10, 20) einen ersten Wert und bei Vorliegen eines nicht eingerasteten Zustands der Phasen- oder Verzögerungsregelschleife (10, 20) einen gegenüber dem ersten Wert unterschiedlichen zweiten Wert annimmt, zu erzeugen und über den Ausgang (35) des Lockdetektors (100; 200) auszugeben
wobei die Bearbeitungsschaltung (50; 250) ein taktflankengesteuertes Flipflop (60; 260) aufweist, das über seinen Datenausgang (64; 264) mit dem Ausgang (35) des Lockdetektors (100; 200) verbunden ist und dazu ausgebildet ist, über seinen Dateneingang (61; 261) die verzögerte Variante (OV1; OV2) des ODER-Verknüpfungssignals (O1) und über seinen Steuereingang (62; 262) das UND-Verknüpfungssignal (U1) als Steuertaktsignal zu empfangen;
wobei
der Lockdetektor (100; 200) einen dritten Eingang (33) zum Empfangen eines Aktivierungssignals (A1) umfasst;
die Bearbeitungsschaltung (50; 250) ein erstes Nicht-Gatter (51) zum Erzeugen einer negierten Variante des Aktivierungssignals (A1) umfasst; und
das taktflankengesteuerte Flipflop (60; 260) ferner dazu ausgebildet ist, über seinen Rücksetzeingang (63) die negierte Variante des Aktivierungssignals (A1) zu empfangen, wobei die Bearbeitungsschaltung (50) eine Ausgabeeinheit (65) umfasst, die dazu ausgebildet ist, bei Vorliegen des eingerasteten Zustands ein an dem Datenausgang (64) des Flipflops (60) anliegendes Ausgangssignal (UL1) zu empfangen, das empfangene Signal zu negieren, das negierte Signal zeitlich um eine oder mehrere Perioden eines von der Phasen- oder Verzögerungsregelschleife (10, 20) als Eingangssignal empfangenen Referenztaktsignals (T1) zu verzögern und das verzögerte Signal als das den ersten Wert annehmenden Zustandssignal (L1) über den Ausgang (35) des Lockdetektors (100) auszugeben, wobei die Ausgabeeinheit (65) ferner dazu ausgebildet ist, bei Vorliegen des nicht eingerasteten Zustands das an dem Datenausgang (64) des Flipflops (60) anliegende Ausgangssignal (UL1) zu empfangen, das empfangene Signal zu negieren und das negierte Signal sofort als das den zweiten Wert annehmende Zustandssignal (L1) über den Ausgang (35) des Lockdetektors (100) auszugeben, wobei die Ausgabeeinheit (65) als Schieberegister ausgebildet ist, wobei das Schieberegister aus einem weiteren taktflankengesteuerten Flipflop besteht, wobei dieser einzige weitere Flipflop (70) des Schieberegisters dazu ausgebildet ist, über seinen Dateneingang (71) das Aktivierungssignal (A1) zu empfangen, über seinen Rücksetzeingang (73) das an dem Datenausgang (64) des Flipflops (60) anliegende Ausgangssignal (UL1) zu empfangen, und über seinen Steuereingang (72) das Referenztaktsignal (T1) als Steuertaktsignal zu empfangen, wobei dieser einzige weitere Flipflop (70) des Schieberegisters über seinen Datenausgang (74) mit dem Ausgang des Lockdetektors verbunden ist; oder wobei das Schieberegister aus mehreren weiteren
taktflankengesteuerten und in Serie geschalteten Flipflops (70, 80, 90) besteht, wobei ein erstes weiteres Flipflop (70) des Schieberegisters dazu ausgebildet ist, über seinen Dateneingang (71) das Aktivierungssignal (A1) zu empfangen, wobei jedes weitere Flipflop (70, 80, 90) des Schieberegisters dazu ausgebildet ist, über seinen Rücksetzeingang (73, 83, 93) das an dem Datenausgang (64) des Flipflops (60) anliegende Ausgangssignal (UL1) und über seinen Steuereingang (72, 82, 92) das Referenztaktsignal (T1) als Steuertaktsignal zu empfangen, wobei ein zweites weiteres Flipflop (90) des Schieberegisters über seinen Datenausgang (94) mit dem Ausgang (35) des Lockdetektors (100) verbunden ist.

2. Lockdetektor (100) nach Anspruch 1, wobei die Verzögerungseinheit (43) ausgebildet ist, zum Erzeugen der verzögerten Variante (OV1) des ODER-Verknüpfungssignals (O1) das ODER-Verknüpfungssignal (O1) um eine Verzögerungszeit (τ), die größer als eine Zeit ist, die einem zulässigen Phasenfehler der Phasen- oder Verzögerungsregelschleife (10; 20) entspricht, zu verzögern.

3. Lockdetektor (100) nach Anspruch 1, wobei jedes weitere Flipflop (70, 80, 90) des Schieberegisters ein taktflankengesteuertes Flipflop mit asynchronem Rücksetzeingang ist.

4. Lockdetektor (200) nach Anspruch 1, wobei die Verzögerungseinheit (243) umschaltbar ist und einen ersten und einen zweiten Schaltzustand aufweist, wobei die in den ersten Schaltzustand geschaltete Verzögerungseinheit (243) ausgebildet ist, zum Erzeugen der verzögerten Variante (OV2) des ODER-Verknüpfungssignals (O1) das ODER-Verknüpfungssignal (O1) um eine erste Verzögerungszeit (τ1) zu verzögern, wobei die in den zweiten Schaltzustand geschaltete Verzögerungseinheit (243) ausgebildet ist, zum Erzeugen der verzögerten Variante (OV2) des ODER-Verknüpfungssignals (O1) das ODER-Verknüpfungssignal (O1) um eine gegenüber der ersten Verzögerungszeit (τ1) längere zweite Verzögerungszeit (τ1') zu verzögern.

5. Lockdetektor (200) nach Anspruch 4, wobei die erste Verzögerungszeit (τ1) größer als eine Zeit ist, die einem zulässigen Phasenfehler der Phasen- oder Verzögerungsregelschleife (10, 20) entspricht.

6. Lockdetektor (200) nach einem der Ansprüche 4 und 5, wobei die Bearbeitungsschaltung (250) einen Multiplexer (251) aufweist, der dazu ausgebildet ist, bei Vorliegen des ersten Wertes des Zustandssignals (L2) am Ausgang (35) des Lockdetektors (200) die Verzögerungseinheit (243) in ihren zweiten Schaltzustand zu schalten und bei Vorliegen des zweiten Wertes des Zustandssignals (L2) am Ausgang (35) des Lockdetektors (200) die Verzögerungseinheit (243) in ihren ersten Schaltzustand zu schalten.

7. Lockdetektor (200) nach einem der Ansprüche 4 bis 6, wobei die Bearbeitungsschaltung (250) ein zweites Nicht-Gatter (252) zum Erzeugen einer negierten Variante des an dem Datenausgang (264) des taktgesteuerten Flipflops (260) anliegenden Ausgangssignals (UL2) und zum Ausgeben der negierten Variante als das Zustandssignal (L2) über den Ausgang (35) des Lockdetektors (200) umfasst.

8. Phasenregelschleife (10) oder Verzögerungsregelschleife (10, 20) mit einem Lockdetektor (100; 200) nach einem der vorangehenden Ansprüche.

## Claims

1. Lock detector (100; 200) for monitoring a phase or delay locked loop (10, 20) having a charge pump (2) controlled by two digital control signals (S1, S2), comprising:
a first input (31) for receiving a first (S1) of the two control signals (S1, S2);
a second input (32) for receiving a second (S2) of the two control signals (S1, S2);
an output (35);
an AND gate (41) for producing an AND logic operation of the two control signals (S1, S2) which is called an "AND logic signal" (U1);
an OR gate (42) for producing an OR logic operation of the two control signals (S1, S2) which is called an "OR logic signal" (O1);
a delay unit (43; 243) for generating a delayed variant (OV1; OV2) of the OR logic signal (O1); and
a processing circuit (50; 250) which is designed to receive the AND logic signal (U1) and the delayed variant (OV1; OV2) of the OR logic signal (O1) and to generate from the received signals a digital state signal (L1; L2) which assumes a first value when a locked-in state of the phase or delay locked loop (10, 20) is present and assumes a second value different from the first value when a non-locked-in state of the phase or delay locked loop (10, 20) is present, and to output it via the output (35) of the lock detector (100; 200),
wherein the processing circuit (50; 250) has a clock-edge-controlled flip-flop (60; 260) which is connected via its data output (64; 264) to the output (35) of the lock detector (100; 200) and is designed to receive the delayed variant (OV1; OV2) of the OR logic signal (O1) via its data input (61; 261) and to receive the AND logic signal (U1) via its control input (62; 262) as a control clock signal;
wherein
the lock detector (100; 200) comprises a third input (33) for receiving an activation signal (A1);
the processing circuit (50; 250) comprises a first NOT gate (51) for generating a negated variant of the activation signal (A1); and
the clock-edge-controlled flip-flop (60; 260) is further designed to receive the negated variant of the activation signal (A1) via its reset input (63), wherein the processing circuit (50) comprises an output unit (65) which is designed, when the locked-in state is present, to receive an output signal (UL1) present at the data output (64) of the flip-flop (60), to negate the received signal, to temporally delay the negated signal by one or more periods of a reference clock signal (T1) received as an input signal by the phase or delay locked loop (10, 20), and to output the delayed signal as the state signal (L1) assuming the first value via the output (35) of the lock detector (100), wherein the output unit (65) is further designed, when the non-locked-in state is present, to receive the output signal (UL1) present at the data output (64) of the flip-flop (60), to negate the received signal and to immediately output the negated signal as the state signal (L1) assuming the second value via the output (35) of the lock detector (100), wherein the output unit (65) is in the form of a shift register, wherein the shift register consists of a further clock-edge-controlled flip-flop, wherein this single further flip-flop (70) of the shift register is designed to receive the activation signal (A1) via its data input (71), and to receive the output signal (UL1) present at the data output (64) of the flip-flop (60) via its reset input (73), and to receive via its control input (72) the reference clock signal (T1) as a control clock signal, wherein this single further flip-flop (70) of the shift register is connected via its data output (74) to the output of the lock detector; or wherein the shift register consists of a plurality of further clock-edge-controlled flip-flops (70, 80, 90) connected in series, wherein a first further flip-flop (70) of the shift register is designed to receive the activation signal (A1) via its data input (71), wherein each further flip-flop (70, 80, 90) of the shift register is designed to receive via its reset input (73, 83, 93) the output signal (UL1) present at the data output (64) of the flip-flop (60) and to receive via its control input (72, 82, 92) the reference clock signal (T1) as a control clock signal, wherein a second further flip-flop (90) of the shift register is connected via its data output (94) to the output (35) of the lock detector (100).

2. Lock detector (100) according to Claim 1, wherein the delay unit (43) is designed to delay the OR logic signal (O1) by a delay time (τ) greater than a time corresponding to a permissible phase error of the phase or delay locked loop (10; 20) in order to generate the delayed variant (OV1) of the OR logic signal (O1).

3. Lock detector (100) according to Claim 1, wherein each further flip-flop (70, 80, 90) of the shift register is a clock-edge-controlled flip-flop with an asynchronous reset input.

4. Lock detector (200) according to Claim 1, wherein the delay unit (243) is switchable and has a first and a second switching state, wherein the delay unit (243) switched to the first switching state is designed to delay the OR logic signal (O1) by a first delay time (τ1) in order to generate the delayed variant (OV2) of the OR logic signal (O1), wherein the delay unit (243) switched to the second switching state is designed to delay the OR logic signal (O1) by a second delay time (τ1') longer than the first delay time (τ1) in order to generate the delayed variant (OV2) of the OR logic signal (O1).

5. Lock detector (200) according to Claim 4, wherein the first delay time (τ1) is greater than a time corresponding to a permissible phase error of the phase or delay locked loop (10, 20).

6. Lock detector (200) according to either of Claims 4 and 5, wherein the processing circuit (250) has a multiplexer (251) which is designed, when the first value of the state signal (L2) is present at the output (35) of the lock detector (200), to switch the delay unit (243) to its second switching state and, when the second value of the state signal (L2) is present at the output (35) of the lock detector (200), to switch the delay unit (243) to its first switching state.

7. Lock detector (200) according to one of Claims 4 to 6, wherein the processing circuit (250) comprises a second NOT gate (252) for generating a negated variant of the output signal (UL2) present at the data output (264) of the clock-controlled flip-flop (260) and for outputting the negated variant as the state signal (L2) via the output (35) of the lock detector (200).

8. Phase locked loop (10) or delay locked loop (10, 20) having a lock detector (100; 200) according to one of the preceding claims.

## Revendications

1. Détecteur de verrouillage (100 ; 200) pour surveiller une boucle de régulation de phase ou de retard (10, 20) comprenant une pompe de charge (2) commandée par deux signaux de commande numériques (S1, S2), comprenant :
une première entrée (31) pour recevoir un premier (S1) des deux signaux de commande (S1, S2) ;
une deuxième entrée (32) pour recevoir un deuxième (S2) des deux signaux de commande (S1, S2) ;
une sortie (35) ;
une porte ET (41) pour générer une opération ET, appelée "signal d'opération ET" (U1), des deux signaux de commande (S1, S2) ;
une porte OU (42) pour générer une opération logique OU, appelée "signal d'opération OU", appelée "signal d'opération OU" (O1), des deux signaux de commande (S1, S2) ;
une unité de retard (43 ; 243) pour générer une variante retardée (OV1 ;
OV2) du signal d'opération OU (O1) ; et
un circuit de traitement (50 ; 250) qui est conçu pour recevoir le signal d'opération ET (U1) et la variante retardée (OV1 ; OV2) du signal d'opération OU (O1) et pour générer, à partir des signaux reçus, un signal d'état numérique (L1 ; L2) qui prend une première valeur en présence d'un état verrouillé de la boucle de régulation de phase ou de retard (10, 20) et prend une deuxième valeur différente de la première valeur en présence d'un état non verrouillé de la boucle de régulation de phase ou de retard (10, 20), et pour l'émettre par l'intermédiaire de la sortie (35) du détecteur de verrouillage (100 ; 200) dans lequel le circuit de traitement (50 ; 250) présente une bascule (60 ; 260) commandée par front d'horloge, qui est reliée par sa sortie de données (64 ; 264) à la sortie (35) du détecteur de verrouillage (100 ; 200) et est conçue pour recevoir par l'intermédiaire de son entrée de données (61 ; 261) la variante retardée (OV1 ; OV2) du signal d'opération OU (O1) et par l'intermédiaire de son entrée de commande (62 ; 262) le signal d'opération ET (U1) en tant que signal d'horloge de commande ;
dans lequel
le détecteur de verrouillage (100 ; 200) comprend une troisième entrée (33) destinée à recevoir un signal d'activation (A1) ;
le circuit de traitement (50 ; 250) comprend une première porte NON (51) pour générer une variante inversée du signal d'activation (A1) ; et
la bascule (60 ; 260) commandée par front d'horloge est en outre conçue pour recevoir la variante inversée du signal d'activation (A1) par l'intermédiaire de son entrée de réinitialisation (63), le circuit de traitement (50) comprenant une unité de sortie (65) conçue pour, en présence de l'état verrouillé, recevoir un signal de sortie (UL1) présent au niveau de la sortie de données (64) de la bascule (60), inverser le signal reçu, retarder le signal inversé d'une ou plusieurs périodes d'un signal d'horloge de référence (T1) reçu en tant que signal d'entrée par la boucle de régulation de phase ou de retard (10, 20), et délivrer le signal retardé en tant que signal d'état (L1) prenant la première valeur par l'intermédiaire de la sortie (35) du détecteur de verrouillage (100), l'unité de sortie (65) étant en outre conçue pour, en présence de l'état non verrouillé, recevoir le signal de sortie (UL1) présent à la sortie de données (64) de la bascule (60), inverser le signal reçu et délivrer immédiatement le signal inversé en tant que signal d'état (L1) prenant la seconde valeur par l'intermédiaire de la sortie (35) du détecteur de verrouillage (100), l'unité de sortie (65) étant conçue sous forme de registre à décalage, le registre à décalage étant constitué d'une autre bascule commandée par front d'horloge, cette unique autre bascule (70) du registre à décalage étant conçue pour recevoir le signal d'activation (A1) par l'intermédiaire de son entrée de données (71), pour recevoir le signal de sortie (UL1) présent à la sortie de données (64) de la bascule (60) par l'intermédiaire de son entrée de réinitialisation (73), et pour recevoir le signal d'horloge de référence (T1) en tant que signal d'horloge de commande par l'intermédiaire de son entrée de commande (72), cette unique autre bascule (70) du registre à décalage étant reliée par l'intermédiaire de sa sortie de données (74) à la sortie du détecteur de verrouillage ; ou le registre à décalage étant constitué de plusieurs autres bascules (70, 80, 90) commandées par front d'horloge et connectées en série, une première autre bascule (70) du registre à décalage étant conçue pour recevoir le signal d'activation (A1) par l'intermédiaire de son entrée de données (71), chaque autre bascule (70, 80, 90) du registre à décalage étant conçue pour recevoir, par l'intermédiaire de son entrée de réinitialisation (73, 83, 93), le signal de sortie (UL1) présent à la sortie de données (64) de la bascule (60) et, par l'intermédiaire de son entrée de commande (72, 82, 92), le signal d'horloge de référence (T1) en tant que signal d'horloge de commande, une deuxième autre bascule (90) du registre à décalage étant reliée par sa sortie de données (94) à la sortie (35) du détecteur de verrouillage (100).

2. Détecteur de verrouillage (100) selon la revendication 1, dans lequel, afin de générer la variante retardée (OV1) du signal d'opération OU (O1), l'unité de retard (43) est conçue pour retarder le signal d'opération OU (O1) d'un temps de retard (τ) qui est supérieur à un temps correspondant à une erreur de phase admissible de la boucle de régulation de phase ou de retard (10 ; 20).

3. Détecteur de verrouillage (100) selon la revendication 1, dans lequel chaque autre bascule (70, 80, 90) du registre à décalage est une bascule commandée par front d'horloge présentant une entrée de réinitialisation asynchrone.

4. Détecteur de verrouillage (200) selon la revendication 1, dans lequel l'unité de retard (243) est commutable et présente un premier et un deuxième état de commutation, l'unité de retard (243) commutée dans le premier état de commutation étant conçue, afin de générer la variante retardée (OV2) du signal d'opération OU (O1), pour retarder le signal d'opération OU (O1) d'un premier temps de retard (τ1), l'unité de retard (243) commutée dans le deuxième état de commutation étant conçue, afin de générer la variante retardée (OV2) du signal d'opération OU (O1), pour retarder le signal d'opération OU (O1) d'un deuxième temps de retard (τ1') qui est plus long que le premier temps de retard (τ1).

5. Détecteur de verrouillage (200) selon la revendication 4, dans lequel le premier temps de retard (τ1) est supérieur à un temps correspondant à une erreur de phase admissible de la boucle de régulation de phase ou de retard (10, 20).

6. Détecteur de verrouillage (200) selon l'une des revendications 4 et 5, dans lequel le circuit de traitement (250) comporte un multiplexeur (251) qui est conçu, en présence de la première valeur du signal d'état (L2) à la sortie (35) du détecteur de verrouillage (200), pour commuter l'unité de retard (243) dans son deuxième état de commutation et, en présence de la deuxième valeur du signal d'état (L2) à la sortie (35) du détecteur de verrouillage (200), pour commuter l'unité de retard (243) dans son premier état de commutation.

7. Détecteur de verrouillage (200) selon l'une quelconque des revendications 4 à 6, dans lequel le circuit de traitement (250) comprend une deuxième porte NON (252) pour générer une variante inversée du signal de sortie (UL2) présent à la sortie de données (264) de la bascule commandée par front d'horloge (260) et pour délivrer la variante inversée en tant que signal d'état (L2) par l'intermédiaire de la sortie (35) du détecteur de verrouillage (200).

8. Boucle de régulation de phase (10) ou boucle de régulation de retard (10, 20) dotée d'un détecteur de verrouillage (100 ; 200) selon l'une quelconque des revendications précédentes.
